# EUROPEAN PATENT APPLICATION

(11) **EP 2 665 117 A1**
(43) Date of publication of application: **20.11.2013**
(21) Application number: 12734419.0
(22) Date of filing: 13.01.2012
(51) Int. Cl.: H01M 4/66, H01G 9/016, H01L 31/04, H01M 8/02

(54) **CURRENT COLLECTOR**

(30) Priority: 14.01.2011 JP 2011006405
(71) Applicant: Showa Denko K.K., Tokyo 105-8518 (JP)
(72) Inventor: YOKOUCHI, Hitoshi, Tokyo 105-8518 (JP); OHMORI, Masahiro, Tokyo 105-8518 (JP); TAKEDA, Akifumi, Tokyo 105-8518 (JP)
(74) Representative: Strehl Schübel-Hopf & Partner
(86) International application number: PCT/JP2012/000168
(87) International publication number: WO 2012/096189

(57) **Abstract**

A current collector wherein Layer ***a*** comprising electrically conductive particles such as electrically conductive carbon; a binding agent such as chitosan, chitin and the like; and organic acid such as trimellitic anhydride, pyromellitic anhydride, 1,2,3,4-butanetetracarboxylic acid and the like is provided on one or both surfaces of a metal foil such as an aluminum foil, a copper foil and the like, and the coverage of the electrically conductive particles is 50 to 100%, and the thickness of the Layer ***a*** is 5 µm or less. An electrode wherein Layer ***b*** comprising an electrode active material is provided on a surface having the Layer ***a*** of the current collector. An electrochemical element comprising the electrode.

## Description

### TECHNICAL FIELD

The present invention relates to a current collector. More specifically, the present invention relates to a current collector used for a fuel cell (see Patent Literature 6); an electrochemical element such as a secondary battery, an electric double layer capacitor and the like; a solar cell (see Patent Literature 3); a touch panel (see Patent Literature 4 or 5); and a sensor (see Patent Literature 7) and the like.

### BACKGROUND ART

As electrochemical elements in a broad sense, known are secondary batteries such as a lithium-ion secondary battery, a nickel-hydrogen battery or the like; and capacitors such as an electric double layer capacitor and a hybrid capacitor. In general, an electrode in an electrochemical element comprises a current collector and an electrode active material layer. The electrode is usually manufactured by applying a coating liquid comprising an electrode active material, a binder and a solvent to a current collector followed by drying.

In order to lower internal resistance or impedance in these secondary batteries and electric double layer capacitors, it is proposed that an electrically conductive material-containing layer is provided between the current collector and the electrode active material layer. For example, Patent Literature 1 discloses a nonaqueous electrolyte secondary battery having an electrically conductive material layer between the positive electrode mixture and the metal current collector. The electrically conductive material layer comprises an electrically conductive material and carboxylmethyl cellulose. Patent Literature 2 describes an electrode body for an electricity storage element comprising a foil-like current collector having two surfaces, an anchor layer formed on at least one of the two surfaces of the current collector and an electrode layer formed on the anchor layer, the anchor layer comprising electrically conductive carbon and a binder, the electrode layer comprising an active material, characterized in that R (R = Rₘₐₓ - Rₘᵢₙ) is 0.5 µm ≤ R ≤ 16 µm and d (d = (Rₘₐₓ + Rₘᵢₙ) /2) is 0.5 µm ≤ d ≤ 20 µm, wherein Rₘₐₓ and Rₘᵢₙ are a maximum and minimum thickness of the anchor layer respectively, R represents a difference between the maximum and minimum thickness of the anchor layer, and d represents a value where a summed value of the maximum and minimum thickness of the anchor layer is multiplied by 0.5.

### PRIOR ARTS LIST

Patent Literature 1: JP 2002-042888 A
Patent Literature 2: JP 2010-108703 A
Patent Literature 3: JP 2002-314108 A
Patent Literature 3: JP H6-175769 A
Patent Literature 5: JP H7-211208 A
Patent Literature 6: JP 2005-285599 A
Patent Literature 7: JP 2011-195394 A

### SUMMARY OF THE INVENTION

### PROBLEMS TO BE RESOLVED BY THE INVENTION

As described above, when an electrically conductive layer comprising electrically conductive particles of electrically conductive carbon and the like and a binder is provided on a surface of a current collector, internal resistance or impedance can be reduced to some extent. However, a demand is increasing for manufacturing an electrochemical element and the like having a high charging capacity and a good cycle property. Therefore, internal resistance or impedance needs to be further reduced.Accordingly, an object of the present invention is to provide a current collector having a low value of penetration resistance, wherein the internal resistance and impedance of an electrochemical element can be significantly decreased.

### MEANS FOR SOLVING THE PROBLEMS

The present inventors conducted extensive studies to achieve the above object. The results revealed that the penetration resistance of a current collector was significantly varied depending on an arrangement of electrically conductive particles and the composition ratio of electrically conductive particles and a binder, and that there exists a range of high resistance conditions inconvenient for decreasing internal resistance and impedance. Further, the results revealed that in a current collector wherein Layer ***a*** comprising electrically conductive particles and a binding agent are provided on one or both surfaces of a metal foil, internal resistance and impedance are significantly reduced by adjusting a coverage of the electrically conductive particles and a thickness of the Layer ***a*** to a specific range. The present invention was completed after conducting further studies based on these findings.

That is, the present invention encompasses the following aspects.
<1> A current collector wherein Layer ***a*** comprising electrically conductive particles and a binding agent is provided on one or both surfaces of a metal foil, and a coverage of the electrically conductive particles is 50 to 100%, and a thickness of the Layer ***a*** is 5 µm or less.
<2> The current collector according to <1>, wherein the binding agent comprises at least one selected from the group consisting of polysaccharides and derivatives thereof.
<3> The current collector according to <1>, wherein the binding agent comprises at least one selected from the group consisting of chitosan, chitin, cellulose and derivatives thereof.
<4> The current collector according to any one of <1> to <3>, wherein the electrically conductive particles are carbonaceous particles.
<5> The current collector according to any one of <1> to <4>, wherein the Layer ***a*** further comprises at least one selected from the group consisting of organic acid and derivatives thereof.
<6> The current collector according to <5>, wherein the organic acid and derivatives thereof are selected from the group consisting of trimellitic anhydride, pyromellitic anhydride and 1,2,3,4-butanetetracarboxylic acid.
<7> The current collector according to any one of <1> to <6>, wherein an amount of the electrically conductive particles contained in the Layer ***a*** is 30 to 90% by mass.
<8> A method of manufacturing the current collector according to any one of <1> to <4>, the method comprising: applying a coating liquid comprising electrically conductive particles, a binding agent and a dispersion medium, but not an electrode active material to one or both surfaces of a metal foil, and then performing a heat treatment to remove the dispersion medium.
<9> The method according to <8>, wherein the coating liquid further comprises at least one selected from the group consisting of organic acid and derivatives thereof.
<10> The method according to <8> or <9>, wherein an amount of the dispersion medium remaining in the Layer ***a*** is 0.1% by mass or less when the heat treatment step ends.
<11> The method according to any one of <8> to <10>, wherein the dispersion medium comprises alcohols.
<12> The method according to any one of <8> to <11>, wherein hot-air drying is used in the heat treatment step.
<13> An electrode wherein Layer ***b*** comprising an electrode active material is provided on a surface having the Layer ***a*** of the current collector according to any one of <1> to <7>.
<14> An electrochemical element (or an electricity storage element) comprising the electrode according to <13>.
<15> A power supply system comprising the electrochemical element (or the electricity storage element) according to <14>.

### ADVANTAGEOUS EFFECTS OF THE INVENTION

The current collector according to the present invention has lower penetration resistance as compared with the conventional current collector. An electrode comprising the current collector can provide an electrochemical element having low internal resistance and impedance; a solar cell; a touch panel and the like.

### EMBODIMENTS FOR CARRYING OUT THE INVENTION

### <Current collector>

The current collector according to the present invention comprises a metal foil and Layer ***a*** provided on one or both surfaces of the metal foil.

### (Metal foil)

As a metal foil to be used for the present invention, not only a foil having no openings but also a foil having openings such as a punching metal foil and a mesh and a porous foil can be used. Further, the metal foil may be a foil having a smoothed surface, or may be a foil having a surface roughened by electrical or chemical etching, i.e., an etched foil.
A thickness of the metal foil is not particularly limited, but preferably 5 µm to 200 µm. Such a thickness can reduce a proportion of the current collector in a predetermined volume of an electrochemical element and the like to a certain level or below, and can provide sufficient strength for a current collector and an electrode to improve a handling property.
A material for the metal foil can be suitably selected depending on applications of the current collector. When the current collector is used for an electrochemical element, a metal having high electrical conductivity and high electrochemical corrosion resistance can be used. For example, when used for a positive electrode of a lithium-ion secondary battery and an electrode of an electric double layer capacitor, a foil of aluminum or an aluminum alloy is preferably used. Examples of an aluminum foil can include foils such as pure aluminum-based materials A1085, A3003 and the like. Further, when used for a negative electrode of a lithium-ion secondary battery, a foil of copper or a copper alloy is preferably used. Examples of a copper foil can include a rolled copper foil and an electrolytic copper foil.

Layer ***a*** comprises electrically conductive particles and a binding agent.

### (Electrically conductive particle)

There is no particular limitation for electrically conductive particles used for Layer ***a*** as long as the particles have electrical conductivity, but those comprising elemental carbon as a main ingredient, i.e., carbonaceous particles are preferred. For carbonaceous particles, carbon black, graphite, vapor grown carbon fiber, carbon nanotube, carbon nanofiber and the like are suitable. Examples of carbon black include acetylene black, furnace black and the like. Commercially available products such as Ketjen black also can be used. These carbonaceous particles can be used alone or in combination of two or more. Electrically conductive particles other than carbonaceous particles can include a powder of metal such as gold, silver, copper, nickel and aluminium, mixtures of these metal powders and carbonaceous particles, or those in which a metal powder is coated on a surface of a carbonaceous particle.

An electrically conductive particle may be a particle having a spherical shape, a scale-like shape, an agglomerative shape, an irregular shape and the like, or may be an anisotropic particle having a needle-like shape, a rod-like shape, a fibrous shape and the like.
Electrically conductive particles having a spherical shape, a scale-like shape, an agglomerative shape, an irregular shape and the like have a mean primary particle diameter of preferably 10 nm to 5 µm, more preferably 10 nm to 100 nm. The mean primary particle diameters of these electrically conductive particles are calculated by measuring particle diameters of 500 to 1000 particles using an electron microscope, and averaging those based on number. Note that in the case of the shapes other than a spherical shape, the largest dimensions (the longest dimensions) are taken as particle diameters, which are then similarly averaged based on number to obtain the mean particle diameter.
An electrically conductive particle having an anisotropic shape has a larger surface area per unit mass and a larger contact area with a metal foil, an electrode active material and the like. Therefore, a small added amount can increase electrical conductivity between the metal foil and the electrode active material or among the electrode active materials. Particularly effective electrically conductive particles having an anisotropic shape include vapor grown carbon fiber, carbon nanotube or carbon nanofiber. In view of improved electrical conductivity, vapor grown carbon fiber, carbon nanotube or carbon nanofiber has a mean fiber diameter of usually 0.001 to 0.5 µm, preferably 0.003 to 0.2 µm, and has a mean fiber length of usually 1 to 100 µm, preferably 1 to 30 µm. Note that a mean fiber diameter and a mean fiber length are calculated by measuring fiber diameters and fiber lengths of 500 to 1000 fibers using an electron microscope, and averaging those based on number.

An electrically conductive particle is preferably 5.0 × 10⁻¹ Ω·cm or less in a powder electrical resistance as measured in accordance with JIS K1469.
Electrically conductive particles are contained in Layer ***a*** in an amount of preferably 30 to 90% by mass, more preferably 40 to 85% by mass, and even more preferably 60 to 80% by mass. This can provide a current collector having Layer ***a*** with low penetration resistance and excellent adherence with a metal foil and an electrode active material layer.

### (Binding agent)

There is no particular limitation for a binding agent used for Layer ***a*** as long as it can bind a metal foil and electrically conductive particles together. However, the binding agent is preferably at least one selected from the group consisting of polysaccharides and derivatives thereof because they have excellent adherence with a metal foil and high ionic permeability. A polysaccharide is a high molecular weight compound in which a large number of monosaccharides or derivatives thereof are polymerized via the glycosidic linkage. A compound in which ten or more monosaccharides or derivatives thereof are polymerized is usually called a polysaccharide, but a compound in which ten or less monosaccharides are polymerized may be used. A monosaccharide which comprises a polysaccharide may be common monosaccharide such as glucose having only a hydroxyl group in a basic scaffold, or may be uronic acid having a carboxyl group and amino sugar having an amino group or an acetylamino group. A polysaccharide may be either a homopolysaccharide or a heteropolysaccharide.
Specific examples of polysaccharides include agarose, amylose, amylopectin, alginic acid, inulin, carrageenan, chitin, glycogen, glucomannan, keratan sulfate, colominic acid, chondroitin sulfate, cellulose, dextran, starch, hyaluronic acid, pectin, pectic acid, heparan sulfate, levan, lentinan, chitosan, pullulan and curdlan. Among these, chitin, chitosan and cellulose are preferred because they have high ionic permeability.

Examples of derivatives of polysaccharides include hydroxyalkylated polysaccharides, carboxyalkylated polysaccharides, sulfuric acid-esterified polysaccharides and the like. In particular, hydroxyalkylated polysaccharides are preferred in view of increased dispersibility in a solvent. Hydroxyalkylated polysaccharides can be manufactured by a known method.
Examples of hydroxyalkyl chitosan can include hydroxyethyl chitosan, hydroxypropyl chitosan, glyceryl chitosan and the like.
Examples of hydroxyalkyl cellulose can include hydroxyethyl cellulose, hydroxypropyl cellulose and the like.
Examples of carboxyalkyl chitosan can include carboxymethyl chitosan, carboxyethyl chitosan and the like.
Examples of carboxyalkyl cellulose can include carboxymethyl cellulose, carboxyethyl cellulose and the like.

Examples of binding agents other than polysaccharides can include the followings:
Fluorine containing polymers such as polyvinylidene fluoride, polytetrafluoroethylene,
tetrafluoroethylene-perfluoroalkyl vinyl ether copolymer, tetrafluoroethylene-hexafluoropropylene copolymer, ethylene-tetrafluoroethylene copolymer and the like; Poly(olefin oxide) such as polyethylene oxide, polypropylene oxide,
polyethylene oxide-propylene oxide copolymer and the like; Elastomer such as styrene butadiene block copolymer, acrylic acid modified SBR resin, gum arabic and the like; Hydroxyl group containing resin such as polyvinyl acetal, ethylene-vinylalcohol copolymer, modified or unmodified polyvinyl alcohol and the like.

A binding agent used for Layer ***a*** has a weight average molecular weight of preferably 1.0 × 10⁴ to 2.0 × 10⁵, more preferably, 5.0 × 10⁴ to 2.0 × 10⁵. When a weight average molecular weight is within this range, the capability for dispersing electrically conductive particles is increased, leading to ***a*** coating liquid having good coating properties, which in turn provides the resulting Layer a with higher strength. A weight average molecular weight can be calculated as a value equivalent to a standard sample such as pullulan using gel permeation chromatography.
The amount of a binding agent to be used is preferably 20 to 300 parts by mass, more preferably 40 to 200 parts by mass, and even more preferably 60 to 100 parts by mass relative to 100 parts by mass of electrically conductive particles.

### (Organic acid)

When a polysaccharide or derivatives thereof is used as a binding agent, preferably, Layer ***a*** further comprises at least one selected from the group consisting of organic acid and derivatives thereof such as carboxylic acid and sulfonic acid. Organic acid or derivatives thereof can serve as a cross-linking agent for a polysaccharide or derivatives thereof, allowing electrically conductive particles to be more firmly placed to a metal foil. Organic acid or derivatives thereof to be used is preferably divalent or higher, more preferably trivalent or higher in view of a high cross-linking effect. Carboxylic acid or derivatives thereof are also preferably used because they do not allow easy elution of metal from the metal foil. Carboxylic acid and derivatives thereof include aromatic carboxylic acid, chain aliphatic carboxylic acid, alicyclic carboxylic acid and derivatives thereof. In view of thermal stability, aromatic carboxylic acid or derivatives thereof is preferred. In view of solubility in water, chain aliphatic carboxylic acid or derivatives thereof is preferred. Derivatives of organic acid include esters, acid chlorides, acid anhydrides and the like. In view of easier cross-linking reaction and fewer by-products, acid anhydrides are preferred.

Aromatic carboxylic acids and derivatives thereof include divalent aromatic carboxylic acids and derivatives thereof such as phthalic acid, isophthalic acid and terephthalic acid; trivalent or higher aromatic carboxylic acids and derivatives thereof such as trimellitic acid, pyromellitic acid, biphenyltetracarboxylic acid and benzophenonetetracarboxylic acid. Among these aromatic carboxylic acids and derivatives thereof, trimellitic anhydride or pyromellitic anhydride is preferred.
Alicyclic carboxylic acids and derivatives thereof include divalent alicyclic carboxylic acids and derivatives thereof such as tetrahydrophtal acid, hexahydrophthalic acid, methylnadic acid, hydrogenated methylnadic acid; trivalent or higher alicyclic carboxylic acids and derivatives thereof such as cyclohexane 1,2,4-tricarboxylic acid and cyclohexane 1,2,4,5-tetracarboxylic acid.
Chain aliphatic carboxylic acids and derivatives thereof include divalent chain aliphatic carboxylic acids and derivatives thereof such as succinic acid, maleic acid, tartaric acid, malic acid, glutaric acid, itaconic acid and adipic acid; trivalent or higher chain aliphatic carboxylic acids and derivatives thereof such as citric acid and 1,2,3,4-butanetetracarboxylic acid. Among the chain aliphatic carboxylic acids and derivatives thereof, 1,2,3,4-butanetetracarboxylic acid is preferred.
These organic acids and derivatives of the organic acids may be used alone or in combination of two or more. The amount of these organic acids and derivative thereof to be used is preferably 30 to 300 parts by mass, more preferably 35 to 120 parts by mass, and even more preferably 40 to 85 parts by mass relative to 100 parts by mass of a polysaccharide and derivatives thereof.

Layer ***a*** may be provided on a portion of a surface of the metal foil, or may be uniformly provided on the entire surface of the metal foil. Modes in which Layer ***a*** is provided on a portion of a surface of the metal foil include a mode in which Layer ***a*** is provided on a central portion of the metal foil except for the edge portion and modes in which Layer ***a*** is provided in a pattern such as a dot pattern, a stripe pattern, a mesh pattern, a lattice (grid) pattern, a nested pattern and a spiral pattern. The proportion of the area of Layer ***a*** relative to the area of the metal foil, A_{R}, is preferably 50 to 100%, more preferably 60 to 100%, and in particular preferably 70 to 100%. The proportion of the area of Layer ***a*** relative to the area of the metal foil, A_{R}, is calculated as follows. The pattern of Layer ***a*** in the current collector is observed from the normal direction at a low magnification through a microscope and the like, and an observation image is photographed at three or more fields. The image is subjected to binary processing with an image analysis technique, and the area Sₐ of the portion in which Layer ***a*** is observed and the area S_{b} of the portion in which Layer ***a*** is not observed are obtained. Using the formula: A_{R} = (Sₐ) / (Sₐ₊S_{b}) × 100, the proportion A_{R} of the area of Layer ***a*** relative to the area of the metal foil is calculated. When Layer ***a*** is provided in a simple and large pattern, the length may be measured using slide calipers and the like to calculate the proportion A_{R} of the area of Layer ***a*.** Note that here, the area of the metal foil is the area of both surfaces of the metal foil when Layer ***a*** is provided on the both surfaces, and the area of one surface of the metal foil when Layer ***a*** is provided on the one surface.

The amount of Layer ***a*** provided on the metal foil is preferably 0.2 to 5 g/m², more preferably 0.5 to 3 g/m², and most preferably 1 to 2 g/m². When such an amount is used, the penetration resistance of a current collector is significantly decreased. By using that current collector, an electrochemical element and the like with low internal resistance and impedance can be manufactured.

### (Thickness of Layer a)

The thickness of Layer ***a*** is preferably 5 µm or less, more preferably 4 µm or less, and even more preferably 3 µm or less. There is no particular limitation for the lower limit of the thickness of Layer ***a*** as long as it is in a range where Layer ***a*** functions, but it is preferably 0.1 µm. When the thickness of Layer ***a*** is within the above range, the penetration resistance of Layer ***a*** is decreased. Therefore, the internal resistance and impedance of an electrochemical element and the like obtained by using the current collector in the present invention can be decreased.

### (Coverage)

The current collector in the present invention has a coverage of electrically conductive particles of 50 to 100%, more preferably 60 to 100%, and even more preferably 70 to 100%. When the coverage is within the above ranges, the penetration resistance of the current collector is decreased. Therefore, the internal resistance and impedance of an electrochemical element obtained by using that current collector can be decreased.
The coverage of electrically conductive particles is computed as follows. First, a portion in the current collector in which Layer ***a*** is provided is observed from the normal direction at a high magnification through a microscope and the like, and an observation image is photographed at three or more fields. Magnification is adjusted so that preferably 100 or more, more preferably 200 or more, and even more preferably 300 or more of electrically conductive particles are seen in one field. Note that the amount of light is adjusted so that the particles are well defined, but no halation occurs. In particular, cautions should be exercised when a highly reflective material such as an aluminum foil is used. The photograph is subjected to binary processing with an image analysis technique, and the area S₁ of the portion in which electrically conducive particles are observed and the area So of the portion in which electrically conducive particles are not observed are obtained. The proportion S₁ of the area of electrically conductive particles relative to the area of Layer ***a*** was designated as the coverage of electrically conductive particles (= (S₁) / (S₁+S₀) × 100) . In the binary processing, the grayscale level of a photographic image was digitized to 0 to 255, and for example, when a threshold was set to 110, 0 to 109 were assigned to "black" while 110 to 255 were assigned to "white." Depending on the types of electrically conductive particles, in a photographic image, some are seen in white, and others are seen in black. For example, when electrically conductive particles seen in white are used, the area of a white portion is an area of electrically conductive particles.
The coverage can be controlled by changing an amount of a dispersion medium used when forming Layer ***a*,** a method of preparing a coating liquid, a method of applying a coating liquid and the like as described below.

### (Penetration resistance)

The penetration resistance of the current collector according to the present invention is preferably 150 mΩ or less, more preferably 100 mΩ or less at 25°C.
Note that the penetration resistance of a current collector is measured as follows. Two strips in a predetermined size are cut out from a current collector, and they are fixed so that the contact surface has a predetermined area and shape when their Layers ***a*** are held together. Each end in which the current collectors do not make a contact was connected to an AC milliohm meter to measure an AC resistance of the current collector, and the measured value was taken as the penetration resistance.

### <A method of manufacturing a current collector>

The method of manufacturing the current collector in the present invention comprises the steps of applying a coating liquid comprising electrically conductive particles, a binding agent and a dispersion medium but not an electrode active material to one or both surfaces of a metal foil, and then performing heat treatment to remove the dispersion medium. Preferably, the coating liquid further comprises at least one selected from the group consisting of organic acid and derivatives thereof.

There is no particular limitation for the dispersion medium used for the coating liquid as long as it can disperse electrically conductive particles, a binding agent and organic acid or derivatives thereof optionally contained therein. Water and an organic solvent are preferably used as the dispersion medium.
Organic solvents include aprotic polar solvents and protic polar solvents.
Aprotic polar solvents include ethers, carbonates, amides, esters and the like. Among these, amides and esters are preferred.
Aprotic polar solvents which evaporate after application at a temperature equal to or below the temperature of heat treatment are preferred. Specifically, those being preferably 50 to 300°C, more preferably 100 to 220°C in a boiling point under ordinary pressure. When an aprotic polar solvent having such the boiling point is used, the concentration of a coating liquid is not easily changed during a coating step. Therefore, Layer ***a*** can be easily obtained with a predetermined thickness or an amount of coating. A dispersion medium can be sufficiently removed by heat treatment. Aprotic polar solvents having the above boiling points include N,N-dimethylacetamide, N-methyl-2-pyrrolidone, N-ethyl-pyrrolidone and γ-butyrolactone. Among these, N-methyl-2-pyrrolidone is preferred.

Meanwhile, protic polar solvents include alcohols and polyvalent alcohols. When a coating liquid contains a protic polar solvent, the wettability of the coating liquid against the current collector can be increased, and the coverage can be uniform within the ranges described above. A protic polar solvent which evaporates after application at a temperature equal to or below the temperature of heat treatment is desirable. Specifically, a protic polar solvent having a boiling point of 100°C or below under normal pressure is preferred. Preferred protic polar solvents include alcohols. More preferred protic polar solvents include ethanol, isopropyl alcohol and n-propyl alcohol.

The amount of a dispersion medium in a coating liquid is preferably 20 to 99% by mass, more preferably 65 to 98% by mass, and even more preferably 80 to 95% by mass. There is no particular limitation for the amount of a protic polar solvent, but it is preferably 1 to 20 % by mass with reference to the total mass of a dispersion medium. Composition ratio of a dispersion medium within these values allows a coating liquid to have appropriate viscosity, achieving good coating workability. Therefore, the amount of coating, the thickness, and the coverage of Layer ***a*** can be easily adjusted within the above ranges, and uniformity can be obtained within a coated surface. Note that increasing a used amount of a dispersion medium reduces the coverage and the thickness while decreasing a used amount of a dispersion medium increases the coverage and the thickness.

The viscosity of a coating liquid is preferably 100 to 50000 mPa·s, more preferably 100 to 10000 mPa·s, and even more preferably 100 to 5000 mPa·s at normal temperature. Viscosity is measured with a Brookfield viscometer with a selected rotor and number of rotations suitable for the viscosity range to be measured. For example, when measuring the viscosity of a coating liquid in a range of hundreds of mPa·s, Rotor No.2 and 60 rpm are appropriate.
Further, when a highly volatile dispersion medium or a low viscous dispersion medium is used, rapid aggregation of electrically conductive particles may occur in the heat treatment described below. In that case, by adding an additive having a dispersion effect, the aggregation can be suppressed, and the coverage can be adjusted within a predetermined range. These additives include propylene glycol monomethyl ether, ethyl lactate, butyl lactate, dipropylene glycol, dipropylene glycol monomethyl ether, propylene glycol, propylene glycol monopropyl ether, ethylene glycol, diethylene glycol monomethyl ether and the like. Among these, propylene glycol or ethylene glycol is preferred, and propylene glycol is particularly preferred.

In addition to the electrically conductive particles, a binding agent, organic acid and derivatives thereof described above, the coating liquid used for the present invention may contain additives such as a dispersing agent, a thickener, an anti-settling additive, an anti-skinning agent, a defoaming agent, an electrostatic coating modifier, an anti dripping agent, a leveling agent, an anti-cratering agent, and a cross-linking catalyst and the like. For each of these additives, a known additive may be used. A preferred loading amount is 10 parts by mass or less relative to the total 100 parts by mass of electrically conductive particles, a binding agent, organic acid and derivatives thereof. The coating liquid can be manufactured by mixing electrically conductive particles, a binding agent, a dispersion medium, and if desired, organic acid or an additive using a mixer. Examples of a mixer include a ball mill, a sand mill, a pigment disperser, a griding mixer, an ultrasonic disperser, a homogenizer, a planetary mixer, a Hobart mixer and the like. There is no particular limitation for a mixing sequence of each component to be contained in a coating liquid, but it is preferred to first prepare a liquid in which a binding agent such as a polysaccharide and a dispersion medium are mixed, to which electrically conductive particles are then added and mixed in order to obtain a uniform coating liquid easily.

In a case where electrically conductive particles in a coating liquid are aggregated, an adjusted coverage and a uniform coating thickness are difficult to be achieved. Accordingly, in order to decease aggregation of electrically conductive particles, the followings can be used: dispersers, disintegrators, grinders and the like in which mechanical sharing such as shearing force, impulse force and shearing stress are used; or dispersers and the like in which ultrasonic irradiation is used. At this time, electrically conductive particles alone may be dry-processed, or electrically conductive particles may be wet-processed after dispersed in an appropriate dispersion medium. They also may be processed in a state of a coating liquid.

There is no particular limitation for methods of applying a coating liquid to a metal foil. For example, they include the casting method, the bar coater method, the dipping method, the printing method and the like. Among these, in view of easy control of the thickness of a coating film, bar coating, gravure coating, gravure reverse coating, roll coating, mayer bar coating, blade coating, knife coating, air knife coating, comma coating, slot die coating, slide die coating and a dip coating are preferred.

Approaches for adjusting the coverage include pattern designing on a coating roll of a gravure coater; use of a stencil type mask or a wire mesh type mask; and the like. In particular, a gravure coater is preferred because it can provide excellent coating uniformity and productivity, and can allow easy alternation of an amount of a coating liquid to be transferred (an amount of coating) and an application position by the design of a concave portion (cell) on the coating roll. There is no particular limitation for a cell design on a coating roll. A shape, arrangement, depth and volume can be adjusted to achieve a target coverage or a target amount of coating. For example, cell patterns include a pyramidal pattern, a grid pattern, a slash pattern, a trapezoidal pattern, a hexagonal pattern, a Rotoflow pattern and the like. One or two or more of these can be arranged in combination on a coating roll, and also can be arranged regularly or irregularly. For example, in the cells with a grid pattern, the region to be applied or the coverage can be adjusted by designing a width and depth of a grid groove.

There is no particular limitation for methods of printing by a gravure coater. They include the direct method, the reverse method, the offset method and the like. Further, Layer ***a*** may be provided by coating once, or may be provided by coating more than once. When coating more than once, a coating pattern can be altered by changing a coating roll.
A coating liquid can be applied to one or both surfaces of a metal foil. Application to both surfaces of a metal foil may be performed by sequential application to one surface at each time or by simultaneous application to the both surfaces.

Heat treatment is performed in order to remove a dispersion medium. There is no particular limitation for methods of heat treatment, but the hot air method is more preferred. Heat treatment temperature is preferably 100 to 300°C, more preferably 120 to 250°C. Heating time is preferably 10 seconds to 10 minutes. Heating under these conditions can maintain productivity while reducing a possibility that a cross-linking reaction may not sufficiently progress, and that organic ingredients in a coating liquid may decompose. In addition, uniformity of an amount of coating, thickness and coverage of Layer ***a*** on a surface can be increased. Further, heating under these conditions can reduce a dispersion medium remained in Layer ***a*,** avoiding a negative effect on the penetration resistance of a current collector. Layer ***a*** may be pressed with a roll or a plate when heat treated.

The amount of a dispersion medium remained in Layer ***a*** is preferably 0.1% by mass or less. There is no particular limitation for methods of measuring a residual amount of a dispersion medium, but quantitative detection is possible by gas chromatography using a column suitable for a specific dispersion medium. For example, in the case of N-methyl-2-pyrrolidone, a current collector sample with known mass is placed in a head space sampler (PerkinElmer Inc., TurbomatrixATD) and heated at 250°C for 30 minutes to evaporate a residual dispersion medium. Then, the vaporized gas in the predetermined amount is sampled from the head space sampler, and introduced into a column (Varian Inc., VF-WAXms) attached to a gas chromatography system (PerkinElmer Inc., Clarus 500 GC/MS). Quantitative analysis is performed by increasing the temperature to 240°C.

### <<Electrode>>

The electrode in the present invention comprises an electrode active material-containing Layer ***b*** provided on a surface having Layer ***a*** of the current collector described above.
There is no particular limitation for materials used for the electrode active material Layer ***b*,** and methods of forming the electrode active material Layer ***b*,** and any known materials and methods used in manufacture of lithium ion secondary batteries, electric double layer capacitors, hybrid capacitors and the like can be employed.
The current collector may be used for an electrode of electrochemical elements other than those described above, or may be used for an electrode of a solar cell, a touch panel, a sensor and the like.

### <<Electrochemical elements (or electricity storage elements)>>

The electrochemical element (or electricity storage element) in the present invention has the aforementioned electrode. Usually, the electrochemical element further has a separator and an electrolyte. With regard to electrodes in an electrochemical element, both of the positive electrode and the negative electrode may be the electrodes according to the present invention. Alternatively either one may be the electrode according to the present invention while the other may not be the electrode according to the present invention. There is no particular limitation for separators as long as they are used in secondary batteries such as lithium ion batteries, electric double layer capacitors, hybrid capacitors and the like. They may be omitted when a solid electrolyte is used as an electrolyte. There is no particular limitation for electrolytes as long as they are used in secondary batteries such as lithium ion batteries, electric double layer capacitors, hybrid capacitors and the like, and they can be any of electrolytic solutions, gel electrolytes, polymer electrolytes, inorganic solid electrolytes or molten salt electrolytes.

The electrochemical element can be used for a power supply system. This power supply system, in turn, can be used for automobiles; transportation equipment such as railroad, ship and aircraft; portable devices such as a cellular phone, a personal digital assistant and a handheld computer; office equipment; power generation systems such as a photovoltaic power generation system, a wind turbine generator system and a fuel cell system; and the like.

### EXAMPLES

Now, the present invention will be described more specifically by using Examples and Comparative Examples. Note that the scope of the present invention shall not be limited to Examples. The current collector, the electrode, the electrochemical element, the power supply system, the touch panel and the solar cell according to the present invention can be suitably modified without departing from the spirit of the present invention.

Properties of current collectors were measured by the following methods.

### (Penetration resistance)

Two sheets of samples were cut out from a current collector in a size of 20 mm in width and 100 mm in length. The two sheets of cutout were allowed to make a contact so that their coating surfaces were faced each other. The contact surface was adjusted to be 20 mm × 20 mm, and placed on a vinyl chloride plate. A load of 1 kg/cm² was applied to the portion in which the two sheets of the current collector make a contact to secure the contact portion. Each of the ends where the two sheets of the current collector do not make a contact each other was connected to an AC milliohm meter to measure a value of penetration resistance (AC resistance) of the current collector.

### (Coverage)

A piece of about 5 mm squared was cut out from a current collector. An image in which 100 or more particles were seen was taken at a magnification of ×2000 through a microscope (KEYENCE CORPORATION, Product name: VHX-900). Note that the amount of light was adjusted so that the particles were well defined, but no halation occurred. The photograph was then subjected to binary processing with an image analysis software (KEYENCE CORPORATION, Product name: Particle Analysis Application VH-H1G1). The coverage was then computed by dividing the area of electrically conductive particles by the total area of the image. In the binary processing, the grayscale level of a photographic image was digitized to 0 to 255, and 0 to 109 were assigned to "black" and 110 to 255 were assigned to "white" with a threshold of 110. The area of "white" portions was computed in this way. In Examples, the area of "white" portions is the area of electrically conductive particles.

### (Thickness)

A portion in which Layer ***a*** is provided and a portion in which Layer ***a*** is not provided were each measured by a micrometer. The thickness of Layer ***a*** was determined by computing the difference.

### (Manufacture of coating liquid and current collector)

### (Examples 1 to 6)

In accordance with the formulation shown in Table 1, raw materials were introduced into a dissolver type mixer, and mixed for 10 minutes at a rotation speed of 300 rpm. Subsequently, a treatment was performed with a homogenizer (IEDA TRADING CORPORATION, Product name: PRO200) for 30 second at 20000 rpm to obtain a coating liquid in which electrically conductive particles and the like were uniformly dispersed in a dispersion medium.
An aluminum foil with a thickness of 30 µm made of a material of alkaline-washed A1085 was prepared. The above coating liquid was applied to the both surfaces of the aluminum foil (except for a tab attachment portion) using an applicator by the casting method. Then, a heat treatment and drying were performed at 180°C for 3 minutes to obtain the current collectors 1 to 6. Properties of the current collectors obtained are shown in Table 1.

[Table 1]

**Table 1**

| | | Example | | | | | |
|---|---|---|---|---|---|---|---|
| | | 1 | 2 | 3 | 4 | 5 | 6 |
| Dispersion medium | | | | | | | |
| | N-methyl-2-pyrrolidone [parts by mass] | 87.5 | 85.0 | 80.0 | 75.0 | 0.0 | 0.0 |
| | Pure water [parts by mass] | 0.0 | 0.0 | 0.0 | 0.0 | 81.0 | 74.0 |
| | Isopropyl alcohol [parts by mass] | 5.0 | 5.0 | 5.5 | 5.5 | 5.0 | 5.0 |

| Electrically conductive particle (A) | | | | | | | |
|---|---|---|---|---|---|---|---|
| | Acetylene black [parts by mass] | 2.5 | 5.0 | 10.0 | 15.0 | 0.0 | 0.0 |
| | Graphite [parts by mass] | 0.0 | 0.0 | 0.0 | 0.0 | 8.0 | 15.0 |

| Binding agent (B) | | | | | | | |
|---|---|---|---|---|---|---|---|
| | Glyceryl chitosan [parts by mass] | 2.5 | 2.5 | 2.5 | 2.5 | 3.0 | 3.0 |

| Organic acid (C) | | | | | | | |
|---|---|---|---|---|---|---|---|
| | Pyromellitic anhydride [parts by mass] | 2.5 | 2.5 | 2.0 | 2.0 | 3.0 | 3.0 |

| Proportion of the electrically conductive particles | | | | | | | |
|---|---|---|---|---|---|---|---|
| | (A)/((A)+(B)+(C))×100 [% by mass] | 33.3 | 50.0 | 69.0 | 76.9 | 57.1 | 71.4 |
| Homogenizer treatment | | yes | yes | yes | yes | yes | yes |
| | | | | | | | |
| Current collector # | | 1 | 2 | 3 | 4 | 5 | 6 |
| | Coverage [%] | 55 | 66 | 83 | 95 | 88 | 99 |
| | Thickness [µm] | 0.5 | 1.1 | 2.5 | 3.2 | 1.5 | 4.3 |
| | Penetration resistance [mΩ] | 150 | 123 | 88 | 78 | 89 | 77 |

### (Comparative Examples 1 to 5)

Coating liquids were obtained by the same approach as in Example 1, except that raw-material recipe was changed to that shown in Table 2. The coating liquids were used to obtain the current collectors a to e. Properties of the current collectors obtained are shown in Table 2.

### (Comparative Example 6)

A coating liquid was obtained by the same approach as in Example 1, except that a raw-material recipe was changed to that shown in Table 2 and the homogenizer treatment was not performed. The coating liquid was used to obtain the current collector f. Properties of the current collector obtained are shown in Table 2.

Tables 1 and 2 show that the current collectors according to the present invention have low penetration resistance, and are suitable as a current collector for electrochemical elements.

[Table 2]

**Table 2**

| | | Comparative Example | | | | | |
|---|---|---|---|---|---|---|---|
| | | 1 | 2 | 3 | 4 | 5 | 6 |
| Dispersion medium | | | | | | | |
| | N-methyl-2-pyrrolidone [parts by mass] | 95.0 | 94.0 | 60.0 | 0.0 | 90.0 | 75.0 |
| | Pure water [parts by mass] | 0.0 | 0.0 | 0.0 | 97.0 | 0.0 | 0.0 |
| | Isopropyl alcohol [parts by mass] | 4.2 | 5.1 | 2.0 | 2.5 | 0.0 | 5.5 |

| Electrically conductive particle (A) | | | | | | | |
|---|---|---|---|---|---|---|---|
| | Acetylene black [parts by mass] | 0.2 | 0.5 | 20.0 | 0.0 | 5.0 | 15.0 |
| | Graphite [parts by mass] | 0.0 | 0.0 | 0.0 | 0.2 | 0.0 | 0.0 |

| Binding agent (B) | | | | | | | |
|---|---|---|---|---|---|---|---|
| | Glyceryl chitosan [parts by mass] | 0.3 | 0.2 | 10.0 | 0.2 | 2.5 | 2.5 |

| Organic acid (C) | | | | | | | |
|---|---|---|---|---|---|---|---|
| | Pyromellitic anhydride [parts by mass] | 0.3 | 0.2 | 8.0 | 0.2 | 2.5 | 2.0 |

| Proportion of the electrically conductive particles | | | | | | | |
|---|---|---|---|---|---|---|---|
| | (A)/((A)+(B)+(C))×100 [% by mass] | 25.0 | 55.6 | 52.6 | 40.0 | 50.0 | 76.9 |
| Homogenizer treatment | | yes | yes | yes | yes | yes | no |
| | | | | | | | |

| Current collector # | | a | b | c | d | e | f |
|---|---|---|---|---|---|---|---|
| | Coverage [%] | 33 | 41 | 99 | 48 | 47 | 77 |
| | Thickness [µm] | 0.3 | 0.4 | 5.5 | 0.4 | 1.3 | 6.4 |
| | Penetration resistance [mΩ] | 400 | 250 | 205 | 300 | 208 | 162 |

### (Manufacture and evaluation of lithium ion batteries)

### (Examples 7 to 12, Comparative Examples 7 to 12)

Samples in a size of 10 cm × 10 cm were cut out from the current collectors obtained in Examples 1 to 6 and Comparative Examples 1 to 6. Slurry was obtained by mixing 95 parts by mass of lithium-cobaltate (NIPPON CHEMICAL INDUSTRIAL CO., LTD., Product name: Cell Seed C), 2 parts by mass of acetylene black (DENKI KAGAKU KOGYO K.K., Product name: Denka Black (powder)), 3 parts by mass of poly(vinylidene fluoride) (KUREHA CORPORATION, Product name: KF polymer #1120) and 95 parts by mass of N-methyl-2-pyrrolidone (industrial grade). This slurry was applied to the both surfaces of the samples cut out from the current collectors (except for a tab attachment portion). Then, they were dried and pressed to form a positive electrode active material layer having a thickness of 50 µm on one surface. These were used for a positive electrode.

Meanwhile, slurry was obtained by mixing 94 parts by mass of artificial graphite (SHOWA DENKO K.K., Product name: SCMG-AR), 1 part by mass of acetylene black (DENKI KAGAKU KOGYO K.K., Product name: Denka Black (powder)), 5 parts by mass of poly(vinylidene fluoride) (KUREHA CORPORATION, Product name: KF polymer #9130) and 94 parts by mass of N-methyl-2-pyrrolidone (industrial grade). This slurry was applied to the both surfaces of an electrolytic copper foil having a thickness of 10 µm (except for a tab attachment portion), and dried and pressed to form a negative electrode active material layer having a thickness of 55 µm on one surface. This was used for a negative electrode.

A separator (POLYPORE INTERNATIONAL, INC., Product name: Celgard 2500) was arranged between the positive and negative electrodes, and the sheets in the number required for a design capacity of 1 Ah were alternately stacked. An aluminum tab electrode and a nickel tab electrode were attached to a non-coating portion of the positive electrode and a non-coating portion of the negative electrode respectively with an ultrasonic welding device. These were placed in a bag-shaped aluminum laminated wrapping material, and moisture was removed in a 60°C vacuum dryer. Then, a LiPF₆ solution (KISHIDA CHEMICAL Co., Ltd.) as an organic electrolysis solution was poured in, and impregnation was performed under the vacuum atmosphere for 24 hours. The opening of the aluminum laminated wrapping material was sealed with a vacuum sealer to manufacture a lithium-ion secondary battery.

The internal resistance of the resulting lithium-ion secondary battery was measured at a measurement frequency of 1 kHz by the AC impedance method using an impedance meter.
Cycle properties of the resulting lithium-ion secondary battery were evaluated by the following approaches. Capacity was measured for each after 200 cycles by sequentially changing the current rate to 0.2 C, 2 C, and 20 C using a charge-discharge device (TOYO SYSTEM Co., Ltd.). Capacity maintenance ratios at 2 C and 20 C were computed based on the capacity at 0.2 C. Note that they were measured at cut voltage of 2.7 to 4.2 V and SOC of 100%. The results are shown in Table 3.

Table 3 shows that the lithium-ion secondary batteries manufactured using the current collectors in the present invention have small internal resistance and excellent cycle properties.

[Table 3]

**Table 3**

| | | | Internal resistance | Capacity maintenance ratio | |
|---|---|---|---|---|---|
| | | | [mΩ] | 2C [%] | 20C [%] |
| Example | 7 | Current Collector 1 | 15 | 94 | 61 |
| | 8 | Current Collector 2 | 13 | 94 | 61 |
| | 9 | Current Collector 3 | 9 | 96 | 63 |
| | 10 | Current Collector 4 | 9 | 96 | 64 |
| | 11 | Current Collector 5 | 9 | 96 | 63 |
| | 12 | Current Collector 6 | 8 | 97 | 64 |
| Comp.Ex. | 7 | Current Collector a | 42 | 91 | 45 |
| | 8 | Current Collector b | 26 | 92 | 49 |
| | 9 | Current Collector c | 22 | 92 | 51 |
| | 10 | Current Collector d | 28 | 92 | 49 |
| | 11 | Current Collector e | 24 | 92 | 50 |
| | 12 | Current Collector f | 19 | 93 | 54 |

### (Manufacture and evaluation of electric double layer capacitors)

### (Examples 13 to 18, Comparative Examples 13 to 18)

A paste was obtained by mixing 100 parts by mass of activated carbon (KURARAY CHEMICAL CO., LTD., Product name: YP-50F), 5 parts by mass of acetylene black (DENKI KAGAKU KOGYO K.K., Product name: Denaka Black (powder)), 7.5 parts by mass of styrene butadiene rubber (NIPPON A&L INC., Product name: Nalstar SR-103), 2 parts by mass of carboxymethylcellulose (DAICEL FINECHEM LTD., Product name: CMC DN-10L) and 200 parts by mass of pure water. This paste was applied to the current collectors obtained in Examples 1 to 6 and Comparative Examples 1 to 6, and dried and pressed to form an electrode layer having a thickness of 80 µm on one surface. This was used for an electrode for an electric double layer capacitor.
Two sheets of the electrode for an electric double layer capacitor were punched out at 20 mmØ in diameter. Two sheets of the electrode were stacked with a separator (NIPPON KODOSHI CORPORATION, Product name TF40) between them, and placed in a capacitor housing for evaluation. An organic electrolytic solution (TOMIYAMA PURE CHEMICAL INDUSTRIES, LTD., Product name: LIPASTE-P/EAFIN (1 mol/L)) was poured into the housing to immerse the electrodes and the like. Finally, the housing was covered with a lid to make an electric double layer capacitor for evaluation.

The impedance of the resulting electric double layer capacitor was measured under the condition of 1 kHz using an impedance measurement device (KIKUSUI ELECTRONICS CORP., Product name: PAN110-5AM).
The capacitance of the resulting electric double layer capacitor was measured as follows. Charge and discharge were performed at current density of 1.59 mA/cm² and 0 to 2.5 V using a charge and discharge test device (HOKUTO DENKO CORP., Product name: HJ-101SM6). The capacitance per cell (F/cell) of the electric double layer capacitor was computed from a discharge curve measured upon the second constant current discharge. Capacitance retention ratio (%) was computed as (capacitance at 50th Cycle) / (capacitance at 2nd Cycle) × 100. The results are shown in table 4.

[Table 4]

**Table 4**

| | | | Impedance | Capacitance | Capacitance retention ratio |
|---|---|---|---|---|---|
| | | | [Ω] | [F] | [%] |
| Example | 13 | Current Collector 1 | 1.55 | 1.65 | 93 |
| | 14 | Current Collector 2 | 1.52 | 1.66 | 94 |
| | 15 | Current Collector 3 | 1.49 | 1.66 | 94 |
| | 16 | Current Collector 4 | 1.49 | 1.67 | 94 |
| | 17 | Current Collector 5 | 1.49 | 1.65 | 95 |
| | 18 | Current Collector 6 | 1.48 | 1.65 | 95 |
| Comp.Ex. | 13 | Current Collector a | 1.72 | 1.64 | 79 |
| | 14 | Current Collector b | 1.66 | 1.64 | 82 |
| | 15 | Current Collector c | 1.69 | 1.67 | 85 |
| | 16 | Current Collector d | 1.69 | 1.64 | 81 |
| | 17 | Current Collector e | 1.68 | 1.67 | 84 |
| | 18 | Current Collector f | 1.65 | 1.67 | 86 |

Table 4 shows that the electric double layer capacitors manufactured using the current collectors in the present invention have low impedance and excellent cycle properties.

## Claims

1. A current collector wherein Layer a comprising electrically conductive particles and a binding agent is provided on one or both surfaces of a metal foil, and a coverage of the electrically conductive particles is 50 to 100%, and a thickness of the Layer a is 5 µm or less.

2. The current collector according to claim 1, wherein the binding agent comprises at least one selected from the group consisting of polysaccharides and derivatives thereof.

3. The current collector according to claim 1, wherein the binding agent comprises at least one selected from the group consisting of chitosan, chitin, cellulose and derivatives thereof.

4. The current collector according to any one of claims 1 to 3, wherein the electrically conductive particles are carbonaceous particles.

5. The current collector according to any one of claims 1 to 4, wherein the Layer ***a*** further comprises at least one selected from the group consisting of organic acid and derivatives thereof.

6. The current collector according to claim 5, wherein the organic acid and derivatives thereof are at least one selected from the group consisting of trimellitic anhydride, pyromellitic anhydride and 1,2,3,4-butanetetracarboxylic acid.

7. The current collector according to any one of claims 1 to 6, wherein an amount of the electrically conductive particles contained in the Layer ***a*** is 30 to 90% by mass.

8. A method of manufacturing the current collector according to any one of claims 1 to 4, the method comprising: applying a coating liquid comprising electrically conductive particles, a binding agent and a dispersion medium, but not an electrode active material to one or both surfaces of a metal foil, and then performing a heat treatment to remove the dispersion medium.

9. The method according to claim 8, wherein the coating liquid further comprises at least one selected from the group consisting of organic acid and derivatives thereof.

10. The method according to claim 8 or 9, wherein an amount of the dispersion medium remaining in the Layer ***a*** is 0.1% by mass or less when the heat treatment step ends.

11. The method according to any one of claims 8 to 10,
wherein the dispersion medium comprises alcohols.

12. The method according to any one of claims 8 to 11,
wherein hot-air drying is used in the heat treatment step.

13. An electrode wherein Layer ***b*** comprising an electrode active material is provided on a surface having the Layer ***a*** of the current collector according to any one of claims 1 to 7.

14. An electrochemical element comprising the electrode according to claim 13.

15. A power supply system comprising the electrochemical element according to claim 14.
